Europäisches Patentamt

European Patent Office

Office européen des brevets

(11) Numéro de publication: **0 045 551**
**B1**

(12) **FASCICULE DE BREVET EUROPEEN**

(45) Date de publication du fascicule du brevet: **31.10.84**

(21) Numéro de dépôt: **81200854.8**

(22) Date de dépôt: **29.07.81**

(51) Int. Cl.³: **C 30 B 1/08,** C 30 B 29/06,
C 30 B 29/40, C 30 B 29/48,
H 01 L 21/268

(54) **Procédé de préparation de films polycristallins semi-conducteurs composés ou élémentaires et films ainsi obtenus.**

(30) Priorité: **05.08.80 LU 82690**
**14.07.81 LU 83490**

(43) Date de publication de la demande:
**10.02.82 Bulletin 82/06**

(45) Mention de la délivrance du brevet:
**31.10.84 Bulletin 84/44**

(84) Etats contractants désignés:
**AT BE CH DE FR GB IT LI NL SE**

(56) Documents cités:
**WO-A-80/00510
DE-A-2 040 140
DE-B-1 057 845
FR-A-2 020 963
FR-A-2 212 177
US-A-4 059 461
US-A-4 212 900**

**APPLIED PHYSICS LETTERS, vol. 35, no. 5, 1er septembre 1979 R. ANDREW et al.: "Laser-induced metal to semiconductor phase transition in mixed Al-Sb films", pages 418-420**

(73) Titulaire: **L'Etat belge, représenté par le Secrétaire Général des Services de la Programmation de la Politique Scientifique 8 rue de la Science B-1040 Bruxelles (BE)**

(72) Inventeur: **Laude, Lucien Diego rue des Lilas 64 Hautmont (FR)**

(74) Mandataire: **Pirson, Jean et al c/o Bureau Gevers, S.A. rue de Livourne, 7 bte 1 B-1050 Brussels (BE)**

(56) Documents cités:
**APPLIED PHYSICS, vol. 17, no. 1, septembre 1978, Springer Verlag 1978 G. VITALI et al.: "Laser induced single crystal transition in polycrystalline silicon", pages 111-113
APPLIED PHYSICS LETTERS, vol. 36, no. 2, janvier 1980 J.C. FAN et al.: "Solid phase growth of large aligned grains during scanned laser crystallization of amorphous Ge films on fused sillica", pages 158-161**

Courier Press, Leamington Spa, England.

**APPLIED PHYSICS LETTERS, vol. 34, no. 2, 15 janvier 1979 R. TSU et al.: "Laser induced recrystallization and damage in GaAs", pages 153-155**

## Description

La présente invention est relative à un procédé de préparation de films polycristallins semiconducteurs composés de deux éléments appartenant respectivement aux Groupes III et V on aux Groupes II et VI du Tableau Périodique, de films polycristallins semi-conducteurs élémentaires, ainsi qu'aux films polycristallins ainsi obtenus.

Il est bien connu que les applications auxquelles pourraient se prêter les composés semi-conducteurs associant les éléments des Groupes III et V et des Groupes II et VI du Tableau Périodique sont nombreuses, en particulier dans le domaine photovoltaïque. Dans ce dernier cas, on a toujours pensé qu'il serait possible de tirer avantage de la variété des bandes interdites de ces matériaux (entre quelque 0,1 eV et 2,5 eV) pour produire le convertisseur de plus haut rendement possible. Celui-ci devrait posséder une bande interdite de 1,6 eV à température ambiante, par exemple, et garder un bon rendement pour des températures de fonctionnement plus élevées de l'ordre de 200°C. Les composés répondant à l'une ou l'autre des conditions sont, entre autres, Ga As (1,35 eV), Al Sb (1,60 eV), InP (1,8 eV), Al As (2,0 eV) (Groupes III et V) et CdS (2,2 eV) et CdTe (1,5 eV) (Groupes II et VI). Néanmoins, des problèmes liés à la fabrication de ces matériaux ont par le passé limité leur développement. Principalement, leur stabilité et leur stoechiométrie ont toujours présenté des difficultés majeures, ce qui s'est traduit par un manque de fiabilité des matériaux produits.

Les méthodes utilisées à ce jour pour réaliser des monocristaux ou des films semi-conducteurs composés sont soit thermiques, soit chimiques. L'intérêt des films réside dans le fait que leur épaisseur peut être contrôlée et, par suite, optimalisée vis-à-vis de la pénétration de la lumière dans le matériau et des propriétés optiques de ce dernier. De ce point de vue, le prix de revient d'une cellule photovoltaïque réalisée à partir d'un film semi-conducteur peut être très inférieur à celui d'une cellule monocristalline. Pour qu'il en soit effectivement le cas, il faut cependant que ces films possèdent une cristallinité très avancée de façon à ce que le transport des charges ne soit pas limité par la granulation du film ("joints de grain"). Or, la dimension des cristallites dans des films préparés thermiquement sur substrat non-orienté amorphe (verre) ne dépasse pas 0,1 $\mu$m en général, les rendant ainsi impropres à la réalisation de jonctions et, par suite, de convertisseurs photovoltaïques. Des dépôts mieux cristallisés (dimension nettement plus grande et orientation préférentielle des cristallites) sont obtenus par dépôt épitaxique sur des substrats orientés, par exemple Ga As sur Ge monocristallin clivé sous vide dont les réseaux atomiques sont très proches. Cependant, il est évident que de telles méthodes (épitaxiques) sont: a) très onéreuses, par l'obligation d'utiliser des substrats demandant une préparation préalable très élaborée; b) limitées à de petites surfaces de l'ordre du cm², sans possibilité de multiplication à grande échelle; c) pratiquement non exploitables dans les systèmes du genre photopile, dans lesquels la base (ici, le substrat du film) devrait être très bon conducteur.

D'autres difficultés ont été recontrées, par exemple dans le cas du composé AlSb qu'il est possible de cristalliser thermiquement à une température de l'ordre de 700°C dans un four sous vide; lorsqu'un film protecteur de SiO est déposé sur le film à traiter préalablement au traitement thermique, on observe que ce dernier provoque bien la cristallisation de AlSb mais aussi sa diffusion dans SiO et, par suite, sa détérioration au contact de l'eau.

L'obtention de films cristallisés élémentaires, par exemple de silicium, par voie thermique est possible à des températures égales ou supérieures à 650°C; toutefois la dimension des cristallites est limitée à quelques 0,1 $\mu$m si le substrat est amorphe. Par voie laser, la cristallisation est aussi obtenue en utilisant un laser en régime continu, balayé sur la surface du film à traiter à une vitesse dépendant du matériau. La dimension des cristallites est de l'ordre de quelques $\mu$m mais leur distribution n'est rendue homogène que si le substrat est lui-même chauffé thermiquement à une température supérieure à 500°C permettant la cristallisation auto-supportée du film. Voir, par exemple, Applied Physics Letter Vol. 36 n° 2, Janvier 1980, résumé et page 160, colonne de gauche, 2ème alinéa.

On citera également comme se rapportant au domaine envisagé la publication d'Applied Physics Letters, Volume 35 n° 5 (1979), pages 418—420, concernant, entre autres, la préparation de films polycristallins semiconducteurs composés de deux éléments appartenant respectivement aux Groupes III et V (aluminium et antimoine), qui consiste à irradier par un faisceau laser, un film composé d'une alternance de couches d'Al et de Sb, ce film étant déposé sur un substrat non cristallin, tel que de la silice, et étant recouvert d'une couche protectrice, telle que du monoxyde de silicium, l'irradiation, en régime pulsé, d'une énergie d'environ 80 mJ/cm², provoquant la cristallisation en cristallites, par exemple d'une dimension de l'ordre du $\mu$m.

L'invention a pour but de remédier aux inconvénients susmentionnés, et d'offrir un procédé de fabrication de films de semi-conducteurs composés et élémentaires:

— possédant des cristallites de très grandes dimensions;
— d'épaisseur de l'ordre de plusieurs $\mu$m et pouvant aller jusqu'à 25 $\mu$m;
— sur support le moins onéreux possible, maintenu à température ambiante ou inférieure à 150°C;
— sur de très grandes surfaces;
— avec une grande facilité, permettant une automatisation avancée de la production.

Le procédé de la présente invention permet en outre de protéger les films préparés contre toute contamination ou altération susceptible d'affecter leur utilisation ultérieure.

A cet effet, suivant l'invention, on irradie par un faisceau laser structuré, dont l'énergie et la séquence de fonctionnement (pulsé ou continu) sont adaptés à l'épaisseur du film à traiter, un film amorphe semi-conducteur élémentaire ou polymétallique composé d'au moins deux couches et de préférence d'une alternance de couches des éléments choisis en proportion stoechiométrique, le film étant déposé sur un substrat non cristallin, de préférence nettoyé sous vide et étant recouvert d'une couche protectrice, l'irradiation structurée provoquant la cristallisation en cristallites régulièrement alignés et de dimension égale ou supérieure à celle du film obtenu.

Selon l'invention, le faisceau laser est structuré par le passage au travers d'un moyen optique agencé pour produire des franges d'interférence.

Suivant une autre forme de réalisation particulière du procédé de l'invention, le faisceau laser est homogénéisé avant d'être structuré, par passage au travers d'une barre cylindrique de quartz coudée deux fois à angle droit en directions opposées, recouverte d'une couche métallique, les faces d'entrée et de sortie de la barre étant polies, parallèles entre elles et perpendiculaires à son axe, le diamètre de ladite barre variant de la face d'entrée à la face de sortie d'un facteur de l'ordre de 2.

Avantageusement, lorsque l'on prépare des films polycristallins de semi-conducteurs composés, les éléments des Groupes III et V ou III et VI du Tableau Périodique sont déposés sur un substrat non cristallin, tel que du verre, en couches alternatives d'épaisseur variant de 50 à 2000 Å selon la nature de l'élément, au moyen d'un canon à électrons, en proportion stoechiométrique, la dernière couche étant recouverte d'une couche de protection, l'épaisseur des diverses couches étant contrôlée par quartz vibrant.

L'invention a également pour objet les films polycristallins semi-conducteurs composés ou élémentaires tels qu'obtenus par les procédés décrits ci-dessus. Les films polycristallins ainsi obtenus ont une épaisseur totale pouvant aller jusqu'à 25 $\mu$m. Comme on le verra ci-après, on peut utiliser différents types de laser en fonction de l'épaisseur des films à cristalliser.

D'autres détails et particularités de l'invention ressortiront de la description donnée ci-après à titre d'exemple non limitatif de quelques formes particulières de l'invention.

a. Préparation des films

La préparation de films composés se fait par dépôts successifs sur substrat amorphe, propre et non orienté comme une plaque de verre, à température ambiante, de couches métalliques successives d'éléments des Groupes III et V ou II et VI du Tableau Périodique, chaque couche étant constituée d'un seul élément. La condensation de ces métaux peut être obtenue par diverses méthodes connues de l'état de la technique; effet Joule, flash, transport en phase vapeur, dépôt électrolytique, pulvérisation cathodique, évaporation sous ultra-vide par bombardement électronique d'une cible du matériau à évaporer; cette dernière méthode a la préférence dans le procédé de l'invention pour sa fiabilité et sa bonne adaptation à une grande variéte de matériaux.

Afin d'assurer une adhérence parfaite du film après le traitement par laser, on réalise le décapage du substrat amorphe (plaque de verre, par exemple) par bombardement ionique d'un gaz neutre (argon, par exemple) pendant quelques minutes (entre 1 et 5 minutes), puis les couches des deux composants A et B sont déposées sur ce substrat. Si l'on utilise une alternance de couches des composants A et B, celles-ci sont alors alternativement déposées sur ce substrat suivant la séquence ABAB...etc. Les épaisseurs respectives des couches de l'élément A et de l'élément B sont contrôlées en cours de dépôt par quartz vibrant. Elles sont strictement dans un rapport tel que les nombres d'atomes A et d'atomes B qui se trouvent dans deux couches voisines AB sont égaux.

Les épaisseurs des couches elles-mêmes sont par ailleurs calculées d'après la valeur, à l'énergie photonique du laser, du coefficient d'absorption optique des éléments, de telle façon que l'énergie optique déposée soit sensiblement la même dans les deux premières couches A et B rencontrées par le faisceau laser en arrivant sur le matériau composité, la dernière couche déposée étant constituée de l'élément le moins absorbant.

Compte tenu de ces arguments, les épaisseurs des couches élémentaires A ou B sont comprises entre 50 et 200 Å, suivant la nature des éléments A et B. Ces épaisseurs peuvent être maintenues constantes sur toute l'épaisseur du film total, celui-ci étant alors constitué d'un empilement homogène et régulier de sandwichs AB. Une autre procédure consiste à réaliser les premiers sandwichs très épais (de 0,1 à 0,5 $\mu$m), c'est-à-dire que chaque couche peut avoir une épaisseur allant jusqu'à 2000 Å, puis réduire graduellement l'épaisseur des sandwichs AB suivants pour atteindre une épaisseur de l'ordre de 150 Å pour le dernier sandwich déposé AB, c'est-à-dire celui qui sera le premier traversé par le rayonnement. L'ensemble de la fabrication peut être automatisée à partir du contrôle permanent d'épaisseur.

Après réalisation d'un film composite suivant l'une des deux procédures ci-dessus et quelle que soit son épaisseur, celui-ci est recouvert d'une couche protectrice d'un matériau tel que le SiO ou l'oxyde d'étain dopé à l'indium (ITO), d'une épaisseur de l'ordre de 300 à 500 Å. Le ITO présente l'avantage d'être bon conducteur électrique tout en restant transparent dans le visible.

La dimension des films réalisés dépend de la caractéristique d'émission des évaporateurs utilisés. Au plus la puissance est élevée, au plus il est possible de préparer de grandes surfaces sans qu'il y ait de gradient d'épaisseur important perpendiculairement à l'axe d'évaporation.

En ce qui concerne la préparation des films de matériaux élémentaires, (silicium, germanium, etc...), on peut utiliser les diverses méthodes bien connues de l'état de la technique, à savoir, par exemple, effet Joule ou canon à électrons pour Ge et canon à électrons pour Si.

b. Irradiation

L'énergie du faisceau laser est réglée suivant la nature des matériaux qui constituent le film. Divers types de laser peuvent être utilisés suivant l'épaisseur des films à cristalliser: laser pulsé à colorant de moyenne puissance et faible énergie (de 50 à 100 mJ/cm$^2$) pour des films d'épaisseur comprise entre 0,015 et 0,2 $\mu$m, ou laser pulsé à rubis de faible énergie (de 50 à 100 mJ/cm$^2$ après filtration) pour des films d'épaisseur de l'ordre de 1 à 2 $\mu$m, ou laser continu à gaz de grande énergie (1 à 5 J/cm$^2$) pour des films d'épaisseur supérieure à 1 $\mu$m pouvant atteindre 25 $\mu$m.

Tous ces films sont déposés sur substrat non cristallin (verre ou silice fondue, par exemple) nettoyé sous vide.

Le faisceau est structuré en le faisant passer au travers de tout moyen optique susceptible de provoquer des franges et pouvant être constitué par soit un réseau optique en quartz gravé dans une lame de quartz, à raison de n lignes par cm, soit une lentille de Fresnel. La structuration du faisceau peut aussi être réalisée en faisant passer celui-ci au travers d'une grille métallique de maille régulière (20 $\mu$m×20 $\mu$m par exemple) disposée perpendiculairement à l'axe du faisceau. Après avoir traversé un de ces systèmes optiques, le faisceau présente une distribution périodique de franges (parallèles aux raies du réseau, par exemple) ou de tâches de lumière (suivant la géométrie de la grille, par exemple).

Le film est alors irradié par ce faisceau structuré. Par exemple, en choisissant un préalable un nombre n convenable de raies par cum sur le réseau, par exemple entre 1000 et 6000, et/ou en faisant varier la distance film-réseau, on obtient sur le film après une pulsation (régime pulsé) du laser, des chaînes rectilignes accolées de cristallites qui donnent à la surface irradiée un aspect homogène dû à la présence de grands cristallites distribués de façon géométrique, compacte et rectiligne. Pour d'autres valeurs de n et/ou de la distance film-réseau, on constate après une pulsation laser, l'existence de chaînes parallèles et rectilignes de cristallites alignés le long d'axes équidistants séparés de la distance d. Ces cristallites sont orientés perpendiculairement à ces axes et la distance d varie avec la distance entre les raies du réseau et proportionnellement à la distance entre film et réseau. Le faisceau laser imprime donc sur le film l'image du réseau (ou de la grille) sous la forme d'alignements de cristallites et il est facilede cristalliser toute la surface en faisant varier soit le nombre de raies du réseau et/ou la distance film-réseau, soit la dimension de la maille de la grille et/ou la distance film-grille.

La superposition de plusieurs "empreintes" du réseau sur le film ne modifie pas la forme de la cristallisation obtenue au cours de la première impression. En déplaçant à vitesse constante le film en regard du faisceau structuré maintenu en position fixe, ou bien en déplaçant le faisceau en regard du film, une ligne de cristallisation de largeur égale au diamètre du faisceau est produite sur toute la longueur du film. Un balayage à deux dimensions permet d'opérer la cristallisation sur toute la surface du film.

Ainsi qu'on l'a déjà précisé, suivant une forme de réalisation préférée de l'invention, avant d'être structuré le faisceau laser peut être rendu homogène par passage au travers de tout moyen optique adéquat connu de l'état de la technique. L'homogénéiseur utilisé est de préférence une barre cylindrique de quartz, de diamètre d'entrée égal au diamètre nominal du faisceau, coudée deux fois à angle droit sur sa longueur, recouverte d'un film métallique comme l'aluminium par exemple, pour limiter les pertes de rayonnement, et se terminant par une réduction éventuelle du diamètre initial d'un facteur choisi en fonction des besoins en surface et en densité énergétique du faisceau. Les faces d'entrée et de sortie de la barre de quartz doivent être précisément perpendiculaires à l'axe du cylindre et polies. A sa sortie, le faisceau laser présente un profil spatial plat sur environ 95% de son diamètre, le reste présentant une forte atténuation, à la périphérie du faisceau.

La cristallisation obtenue est aisément identifiée en analysant la transmission d'un faisceau en lumière blanche au travers du film. Par exemple, dans le cas du système AlSb, le film présente une coloration orange caractéristique du composé sur toute l'étendue du film, alors qu'il demeure entièrement opaque dans le visible avant irradiation.

Il est évident que le procédé suivant l'invention peut être appliqué à tout film composite ou élémentaire, quelle que soit sa surface, en faisant varier:

— l'énergie du faisceau laser en fonction de la nature des composants utilisés;

— le nombre n de raies par cm du réseau;

— la distance entre film et réseau;
— la dimension et la géométrie de la maille de la grille;
— la distance entre film et grille;
— les paramètres du balayage de la surface.

Toutes ces variables sont très facilement ajustables sur banc d'optique, ne nécessitent pas une mise au point longue et délicate et, par conséquent, rendent le procédé aisément adaptable à tout film et fiable au niveau d'une exploitation à grande échelle. L'automatisation du balayage permet d'autre part de réduire encore les interventions manuelles de l'opérateur.

Parmi les autres avantages de l'invention, il faut signaler que la cristallisation s'opère sans altérer le film protecteur qui est transparent aux photons du laser, de sorte que les cristallites se trouvent protégés dès leur formation de toute interaction avec le milieu, en particulier la vapeur d'eau, quelle que soit la dimension des cristallites et pour toute épaisseur de film.

Par ailleurs, la cristallisation ne s'accompagne pas de diffusion dans la couche protectrice, ceci étant dû à la durée très courte de l'irradiation, et donc de la transformation, au contraire de ce qui est mis en pratique dans d'autres procédés de cristallisation par laser.

Les problèmes associés à l'existence des joints de grain dans un film semi-conducteur polycristallin sont dans le cas du procédé de la présente invention très atténués, sinon complètement annihilés. La dimension des cristallites obtenus est en effet supérieure à l'épaisseur des couches, c'est-à-dire que pratiquement les seuls joints de grain présents dans le film relient directement la face avant (recouverte de la couche protectrice) et la face arrière (sur substrat) du film. Le transport électronique entre ces deux faces est donc très proche de celui rencontré dans les monocristaux, les joints de grain se trouvant alors "court-circuités" par les cristallites. Le transport latéral n'en est pas moins amélioré par la réduction globale, de l'ordre de $10^3$, des joints de grain par rapport aux films obtenus thermiquement. Ceci permet de réduire de façon très importante (plusieurs ordres de grandeur) la résistance série $R_s$ des films cristallisés. On sait que la $R_s$ est un paramètre très critique ($R_s$ doit être la plus faible possible) qui commande le fonctionnement de pile photovoltaïque à partir de films semi-conducteurs polycristallins.

Les exemples qui suivent illustrent l'invention sans toutefois la limiter.

Exemple 1
Film de AlSb

a) Un film de 2,5 $\mu$m d'épaisseur est réalisé par dépôts successifs de couches de Al et de Sb, de respectivement 50 Å et 92 Å d'épaisseur, sur un substrat de verre de 2 cm sur 2 cm, par évaporation sous ultra-vide par bombardements électroniques successifs d'une cible de Al et d'une cible de Sb, avec un appareil d'une puissance de 6 KW. La vitesse de dépôt étant de 10 Å/sec., la réalisation du film demande environ 3/4 d'heure. La préparation du film se termine par le dépôt d'une couche de 400 Å de monooxyde de silicium ou de ITO, déposée par la même technique. A tous les stades de la préparation, l'épaisseur des couches est contrôlée par quartz vibrant.

Sur un banc optique, on monte un homogénéiseur de faisceau à la sortie d'un laser à rubis pulsé, d'énergie atténuée par filtre optique dans la gamme de 50 à 100 mJ/cm², la durée des pulsations étant de $2 \times 10^{-8}$ sec. L'homogénéisation est réalisée par un barreau cylindrique de quartz coudé deux fois à angle droit, en directions opposées; le barreau est recouvert d'une couche d'aluminium et ses deux faces sont polies, parallèles entre elles et perpendiculaires à l'axe du barreau; la face du barreau opposée à celle placée dans l'axe du faisceau a une surface deux fois moindre que cette dernière; le diamètre de la face de sortie est de 3 mm; la face d'entrée a le diamètre du faisceau. On place devant la sortie du barreau, perpendiculairement à celui-ci, un réseau optique en quartz, comportant 4000 raies par cm. Le film préparé ci-dessus est placé devant le réseau à une distance d'environ 1 mm et parallèlement à celui-ci.

On irradie le film déposé sur le support de verre par une pulsation laser de 65 mJ/cm² d'énergie et de $2 \times 10^{-8}$ seconde de durée. On observe alors sur toute la surface irradiée des alignements réguliers et parallèles de cristallites dont les dimensions varient autour de 3 $\mu$m et orientés perpendiculairement aux raies du réseau. Ces alignements, distants d'environ 6 $\mu$m, sont orientés parallèlement aux alignements de grands cristallites.

b) On déplace alors le film linéairement dans son plan à une vitesse telle que les pulsations successives du laser viennent frapper le film en recouvrant 90% de la surface touchée par la pulsation précédente; on obtient ainsi sur le film une zone cristallisée rectangulaire, de largeur égale à la dimension du faisceau laser, et constituée de cristallites régulièrement alignés.

c) En répétant le même essai avec un réseau comportant 2000 raies par cm et avec une distance film/réseau de 1 mm, on obtient après une pulsation, des alignements parallèles de cristallites d'environ 3 $\mu$m; ces alignements distants l'un de l'autre d'environ 3 $\mu$m sont ici contigus, au contraire du cas précédent en b).

d) En répétant le même essai, mais en supprimant le réseau optique du trajet du faisceau laser, on obtient après une pulsation des cristallites orientés en tous sens, beaucoup plus petits qu'en présence du réseau (en moyenne, environ 500 Å). Le même essai encore, mais en supprimant réseau et homogénéiseur, fournit des cristallites orientés en tous sens, de taille très variée entre 0,1 et 2 $\mu$m.

## Exemple 2
### Film de AlSb

a) Un film de 7 $\mu$m d'épaisseur est réalisé par dépôts successifs de Al et Sb comme précédemment, sur un substrat de verre décapé sous vide par bombardement ionique comme décrit plus haut. La réalisation de ce film dure 2 heures et demi, le film étant protégé par SiO.

L'irradiation de ce film est réalisée avec un laser à gaz (Krypton) continu de forte énergie (3 J/cm$^2$) mais de faible puissance comparée aux deux autres lasers pulsés (colorant et rubis). Sans utilisation d'un homogénéiseur (le faisceau est très stable et homogène), l'irradiation provoque une cristallisation à grands cristallites dans la zone irradiée bordée d'une cristallisation beaucoup plus fine. Typiquement, si le diamètre du spot est limité à 50 $\mu$m, des grands cristallites de quelques dizaines de micron apparaissent sur cette dimension, la frange de microcristallites occupant une couronne de 2—3 $\mu$m de largeur à la périphérie.

b) Le film est déplacé alors perpendiculairement à l'axe du faisceau à une vitesse de 1 mm/sec. La cristallisation en régime ainsi dynamique produit des cristallites AlSb de type dendritique, alignés sensiblement dans l'axe du déplacement, de largeur égale à~10 $\mu$m, sur une longueur de 100 $\mu$m en moyenne, atteignant 200 $\mu$m dans certaines situations.

c) En utilisant un faisceau initialement identique au précédent, puis structuré par passage au travers d'une grille métallique de maille égale à 80×80 et de section égale à quelques mm$^2$, le film qui reste immobile devant le faisceau est cristallisé suivant les mêmes caractéristiques (dimension des cristallites) que précédemment sur toute la surface irradiée. Un déplacement du film à la vitesse de 1 mm/sec. produit alors une cristallisation beaucoup plus importante que suivant la géométrie de l'irradiation précédente. Typiquement, il faut 3 minutes pour irradier et cristalliser un film d'épaisseur de 7 $\mu$m sur une surface de 4 cm$^2$.

## Exemple 3
### Film de AlAs

a) Un film de 0,1 $\mu$m d'épaisseur est réalisé par dépôts successifs de couches de Al et de As, respectivement d'une épaisseur de 50 Å et de 80 Å, et recouvert de SiO, selon la technique décrite pour le film de AlSb, Le film est placé devant le système optique décrit dans l'exemple 1. Toutefois, pour l'épaisseur de film envisagée, on utilise un laser à colorant de 6 KW, la distance film-réseau étant de 1 mm. L'irradiation se fait à une énergie d'environ 65 mJ/cm$^2$ et à une durée de 10$^{-6}$ sec. On obtient des cristallites de même dimension que ceux obtenus dans l'exemple 1 aux mêmes épaisseurs.

b) Un film de 0,2 $\mu$m d'épaisseur est réalisé par dépôts successifs de deux couches de Al et de As, respectivement de 800 Å et de 1200 Å d'épaisseur. On procède comme dans a) ci-dessus, et l'on obtient également des cristallites de même dimension que ceux obtenus dans l'exemple 1 aux mêmes épaisseurs.

## Exemple 4
### Film de Si

En utilisant les divers dispositifs d'irradiation par laser décrits ci-dessus pour des films amorphes de Si, d'épaisseur correspondant au laser utilisé, on obtient une cristallisation à gros cristaux de taille comprise entre 1 et 20 $\mu$m distribués géométriquement et de façon homogène sur toute la surface irradiée.

## Exemple 5

Un film de 0,2 $\mu$m d'épaisseur est réalisé par dépôts successifs de deux couches de Cd et de Te de telle façon que les nombres d'atomes de Cd et Te soient égaux, puis l'ensemble est recouvert d'une couche de SiO, le tout étant déposé sur une plaque de verre nettoyée sous vide au préalable par pulvérisation sous gaz neutre. Le système ainsi réalisé est alors irradié par une seule pulsation de durée 10$^{-6}$ sec. fournie par un laser à colorant travaillant sensiblement à 2 eV d'énergie photonique et d'énergie totale voisine de 60 mJ/cm$^2$. La transformation du film polymétallique Cd/Te sur verre en un film semi-conducteur CdTe est alors constatée sur toute la surface irradiée, par mesure de la réflectivité optique, avec un seuil d'absorption optique au voisinage de 1,5 eV (ou 820 nm de longueur d'onde). Une fois le faisceau structuré, l'irradiation d'une pulsation provoque une cristallisation de même qualité que celle rapportée dans les exemples 1, 2 et 3.

Il est bien entendu que l'invention n'est pas limitée aux formes de réalisation décrites et que bien des modifications peuvent y être envisagées.

## Revendications

1. Procédé de préparation de films polycristallins semi-conducteurs composés de deux éléments appartenant respectivement aux Groupes III et V ou aux Groupes II et VI du Tableau Périodique, comprenant l'irradiation par un faisceau laser d'un film composé d'au moins deux couches des éléments choisis en proportion stoechiométrique, le film étant déposé sur un substrat non cristallin et étant recouvert d'une couche protectrice, ce procédé étant caractérisé en ce qu'il consiste à irradier ledit film par un faisceau laser structuré de manière à provoquer la cristallisation en cristallites régulièrement alignés et de dimension au moins égale à l'épaisseur du film obtenu, le faisceau laser étant structuré par passage au travers d'un moyen optique agencé pour produire des franges d'interférence.

2. Procédé suivant la revendication 1, caractérisé en ce que ledit film est composé d'une alternance de couches des éléments choisis en proportion stoechiométrique.

3. Procédé de préparation de films polycristallins semi-conducteurs élémentaires, comprenant l'irradiation par un faisceau laser d'un film semi-conducteur amorphe élémentaire, le film étant déposé sur un substrat non cristallin et étant recouvert d'une couche protectrice, ce procédé étant caractérisé en ce qu'il consiste à irradier ledit film par un faisceau laser structuré de manière à provoquer la cristallisation en cristallites régulièrement alignés et de dimension au moins égale à l'épaisseur du film obtenu, le faisceau laser étant structuré par passage au travers d'un moyen optique agencé pour produire des franges d'interférence.

4.- Procédé suivant l'une quelconque des revendications 1 à 3, caractérisé en ce que le substrat non cristallin est nettoyé par bombardement ionique d'un gaz neutre, tel que l'argon.

5. Procédé suivant l'une quelconque des revendications 1 à 4, caractérisé en ce que les cristallites ont une dimension supérieure à l'épaisseur du film obtenu.

6. Procédé suivant l'une quelconque des revendications 1 à 5, caractérisé en ce que le moyen optique agencé pour produire des franges d'interférence est constitué par un réseau optique en quartz, gravé.

7. Procédé suivant la revendication 6, caractérisé en ce que le nombre de raies gravées du réseau optique en quartz et la distance réseau-film ont des valeurs telles que le faisceau laser provoque une cristallisation régulière sur toute la surface du faisceau en cristallites alignés.

8. Procédé suivant la revendication 7, caractérisé en ce que le nombre de raies du réseau optique varie entre 1000 et 6000 par cm.

9. Procédé suivant l'une ou l'autre des revendications 7 et 8, caractérisé en ce que la distance réseau-film est de l'ordre de 1 mm.

10. Procédé suivant l'une quelconque des revendications 1 à 5, caractérisé en ce que le moyen optique agencé pour produire des franges d'interférence est constitué par une lentille de Fresnel.

11. Procédé suivant l'une quelconque des revendications 1 à 5, caractérisé en ce que le moyen optique agencé pour produire des franges d'interférence est constitué par une grille métallique de maille régulière disposée perpendiculairement à l'axe du faisceau.

12. Procédé suivant l'une quelconque des revendications 1 à 11, caractérisé en ce que le faisceau laser irradiant le film est en régime pulsé et d'énergie comprise entre 50 et 100 mJ/cm².

13. Procédé suivant l'une quelconque des revendications 1 à 11, caractérisé en ce que le faisceau laser irradiant le film est en régime continu et d'énergie comprise entre 1 et 5 J/cm².

14. Procédé suivant l'une quelconque des revendications 1 à 13, caractérisé en ce que le faisceau laser est homogénéisé avant d'être structuré.

15. Procédé suivant la revendication 14, caractérisé en ce que le faisceau laser est homogénéisé par passage au travers d'une barre cylindrique de quartz coudée deux fois à angle droit en directions opposées, recouverte d'une couche métallique, les faces d'entrée et de sortie de la barre étant polies, parallèles entre elles et perpendiculaires à son axe, le diamètre de ladite barre variant de la face d'entrée à la face de sortie d'un facteur de l'ordre de 2.

16. Procédé suivant l'une quelconque des revendications 1 à 15, caractérisé en ce que l'épaisseur du film est comprise entre 1 et 2 μm et en ce que le faisceau laser est un faisceau laser pulsé à rubis.

17. Procédé suivant l'une quelconque des revendications 1 à 16, caractérisé en ce que l'épaisseur du film est comprise entre 2 et 25 μm et en ce que le faisceau laser est un faisceau laser continu.

18. Procédé suivant l'une quelconque des revendications 1 à 17, caractérisé en ce que la couche de protection est constituée de monoxyde de silicium ou d'oxyde d'étain dopé à l'indium.

19. Procédé suivant l'une quelconque des revendications 1, 2 et 4 à 18, caractérisé en ce que les éléments des Groupes III et V ou II et VI du Tableau Périodique sont déposés sur un substrat non cristallin en couches alternatives d'épaisseur variant de 50 à 2000 Å selon la nature de l'élément, au moyen d'un canon à électrons, en proportions stoechiométriques, la dernière couche étant recouverte d'une couche de protection, l'épaisseur des diverses couches étant contrôlée par quartz vibrant.

20. Procédé suivant la revendication 19, caractérisé en ce que les épaisseurs de deux couches élémentaires différentes immédiatement voisines varient chacune entre 50 et 200 Å et sont maintenues constantes sur toute l'épaisseur du film total, de manière à obtenir un empilement homogène et régulier de ces deux couches élémentaires différentes.

21. Procédé suivant la revendication 20, caractérisé en ce que l'on réduit graduellement l'épaisseur des couches élémentaires sur le substrat au fur et à mesure qu'on les dépose.

22. Procédé suivant la revendication 21, caractérisé en ce que les premiers sandwichs ont une épaisseur de l'ordre de 0,1 à 0,5 μm et en ce que le dernier sandwich a une épaisseur de l'ordre de 150 Å, chaque sandwich étant formé de deux couches élémentaires différentes immédiatement voisines.

23. Procédé suivant l'une quelconque des revendications 20 à 22, caractérisé en ce que la dernière couche déposée est constituée de l'élément le moins absorbant.

24. Procédé suivant l'une quelconque des revendications 1, 2 et 4 à 23, caractérise en ce que les éléments des Groupes III et V sont choisis respectivement parmi les couples d'éléments comprenant l'aluminium et l'antimoine, l'aluminium et l'arsenic, le galium et l'arsenic, et l'indium et le phosphore.

25. Procédé suivant l'une quelconque des revendications 1, 2 et 4 à 23, caractérisé en ce que les éléments des Groupes II et VI sont choisis respectivement parmi les couples d'éléments comprenant le cadmium et le soufre, et le cadmium et le tellure.

26. Procédé suivant l'une quelconque des revendications 3 à 18, caractérisé en ce que l'élément utilisé est du silicium ou du germanium.

**Patentansprüche**

1. Verfahren zur Herstellung von polykristallinen Halbleiterschichten, die aus zwei Elementen der III. und V. oder II. und VI. Gruppe des periodischen System bestehen, wobei mit einem Laserstrahlenbündel eine Schicht bestrahlt wird, die aus wenigstens zwei Schichten der im stöchiometrischen Verhältnis gewählten Elemente besteht und auf ein nicht kristallines Substrat aufgebracht und mit einer Schutzschicht bedeckt ist, dadurch gekennzeichnet, daß die Schicht mit einem Laserstrahlenbündel bestrahlt wird, derart, daß die Kristallisation zu regelmäßig ausgerichteten Kristalliten mit einer Abmessung von wenigstens gleich der Dicke der erhaltenen Schicht hervorgerufen wird und daß das Laserstrahlenbündel strukturiert wird, indem es durch eine optische Einrichtung hindurchtritt, die zum Erzeugen von Interferenzstreifen ausgebildet ist.

2. Verfahren nach Anspruch 1, dadurch gekennzeichnet, daß die Schicht aus einer Wechselfolge von Schichten der im stöchiometrischen Verhältnis gewählten Elemente zusammengesetzt ist.

3. Verfahren zum Herstellen von polykristallinen, elementaren Halbleiterschichten, bei dem mit einem Laserstrahlenbündel eine amorphe, elementare Halbleiterschicht bestrahlt wird, die auf ein nicht kristallines Substrat aufgebracht und mit einer Schutzschicht bedeckt ist, dadurch gekennzeichnet, daß die Schicht mit einem Laserstrahlenbündel bestrahlt wird, derart, daß die Kristallisation zu regelmäßig ausgerichteten Kristalliten mit einer Abmessung von wenigstens gleich der Dicke der erhaltenen Schicht hervorgerufen wird und daß das Laserstrahlenbündel strukturiert wird, indem es durch eine optische Einrichtung hindurchtritt, die zum Erzeugen von Interferenzstreifen ausgebildet ist.

4. Verfahren nach einem der Ansprüche 1 bis 3, dadurch gekennzeichnet, daß das nicht kristalline Substrat durch Ionenbeschießen mit einem neutralen Gas, wie Argon gereinigt wird.

5. Verfahren nach einem der Ansprüche 1 bis 4, dadurch gekennzeichnet, daß die Kristallite eine größere Abmessung als die Dicke der erhaltenen Schicht aufweisen.

6. Verfahren nach einem der Ansprüche 1 bis 5, dadurch gekennzeichnet, daß die zum Erzeugen von Interferenzstreifen ausgebildete, optische Einrichtung ein geritztes, optisches Gitter aus Quarz ist.

7. Verfahren nach Anspruch 6, dadurch gekennzeichnet, daß die Anzahl der geritzten Striche des optischen Gitters aus Quarz und der Abstand zwischen dem Gitter und der Schicht solche Werte aufweisen, daß das Laserstrahlenbündel über die gesamte Oberfläche des Gitters eine regelmäßige Kristallisation von ausgerichteten Kristalliten hervorruft.

8. Verfahren nach Anspruch 7, dadurch gekennzeichnet, daß die Anzahl der Striche des optischen Gitters zwischen 1000 und 6000 pro Zentimter liegt.

9. Verfahren nach Anspruch 7 oder 8, dadurch gekennzeichnet, daß der Abstand zwischen dem Gitter und der Schicht in der Größenordnung von 1 mm liegt.

10. Verfahren nach einem der Ansprüche 1 bis 5, dadurch gekennzeichnet, daß die zum Erzeugen von Interferenzstreifen ausgebildete, optische Einrichtung eine Fresnel-Linse ist.

11. Verfahren nach einem der Ansprüche 1 bis 5, dadurch gekennzeichnet, daß die zum Erzeugen von Interferenzstreifen ausgebildete, optische Einrichtung von einem Metallgitter mit regelmäßigen Maschen gebildet wird, welches senkrecht zu der Achse des Strahlenbündels angeordnet ist.

12. Verfahren nach einem der Ansprüche 1 bis 11, dadurch gekennzeichnet, daß das die Schicht bestrahlende Laserstrahlenbündel gepulst wird und eine Energie zwischen 50 und 100 mJ/cm² aufweist.

13. Verfahren nach einem der Ansprüche 1 bis 11, dadurch gekennzeichnet, daß das den Film bestrahlende Laserstrahlenbündel kontinuierlich betrieben wird und eine Energie zwischen 1 und 5 J/cm² aufweist.

14. Verfahren nach einem der Ansprüche 1 bis 13, dadurch gekennzeichnet, daß das Laserstrahlenbündel gleichförmig gemacht wird, bevor es strukturiert wird.

15. Verfahren nach Anspruch 14, dadurch gekennzeichnet, daß das Laserstrahlenbündel gleichförmig gemacht wird, indem es durch einen zylinderförmigen Quarzstab gelenkt wird, der zweimal unter einem rechten Winkel in entgegengesetzten Richtungen abgewinkelt und mit einer Metallschicht bedeckt ist, daß die Eintrittsfläche und die Austrittsfläche des Stabes poliert und parallel zueinander und senkrecht zu seiner Achse sind und daß sich der Durchmesser des Stabes von der Eintrittsseite zu der Austrittsseite um einem Faktor der Größenordnung von 2 ändert.

16. Verfahren nach einem der Ansprüche 1 bis 15, dadurch gekennzeichnet, daß die Dicke der Schicht zwischen 1 und 2 $\mu$m liegt und das Laserstrahlenbündel ein Strahlenbündel eines gepulsten Rubinlasers ist.

17. Verfahren nach einem der Ansprüche 1 bis 16, dadurch gekennzeichnet, daß die Dicke der Schicht zwischen 2 und 25 $\mu$m liegt und daß das Laserstrahlenbündel das Strahlenbündel eines kontinuierlichen Lasers ist.

18. Verfahren nach einem der Ansprüche 1 bis 17, dadurch gekennzeichnet, daß die Schutzschicht aus Siliciummonoxid oder mit Indium dotiertem Zinnoxid gebildet wird.

19. Verfahren nach einem der Ansprüche 1, 2 oder 4 bis 18 dadurch gekennzeichnet, daß die Elemente der III. und V. oder II. und VI. Gruppe des periodischen Systems auf einem nicht kristallinen Substrat mit abwechselnden Schichten einer Dicke zwischen 50 und 2000 Å entsprechend der Eigenart des Elementes mittels einer Elektronenkanone im stöchiometrischen Verhältnis aufgebracht werden, wobei die letzte Schicht mit einer Schutzschicht bedeckt wird und die Dicke der verschiedenen Schichten mit einem Schwingungsquarz gesteuert wird.

20. Verfahren nach Anspruch 19, dadurch gekennzeichnet, daß die Dicken von zwei elementaren, unterschiedlichen, unmittelbar benachbarten Schichten jeweils zwischen 50 und 200 Å liegen und über die ganze Dicke der gesamten Schicht konstant gehalten werden, derart, daß eine gleichförmige und regelmäßige Packung der zwei unterschiedlichen, elementaren Schichten erhalten wird.

21. Verfahren nach Anspruch 20, dadurch gekennzeichnet, daß man allmählich die Dicke der elementaren Schichten auf dem Substrat in dem Maße verringert, wie man sie aufbringt.

22. Verfahren nach Anspruch 21, dadurch gekennzeichnet, daß die ersten Schichtanordnungen eine Dicke in der Größenordnung von 0,1 bis 0,5 μm aufweisen und daß die letzte Schichtanordnung eine Dicke in der Größenordnung von 150 Å aufweist, wobei jede Schichtanordnung aus zwei elementaren, unterschiedlichen, unmittelbar benachbarten Schichten gebildet ist.

23. Verfahren nach einem der Ansprüche 20 bis 22, dadurch gekennzeichnet, daß die letzte aufgebrachte Schicht aus dem weniger absorbierenden Element gebildet ist.

24. Verfahren nach einem der Ansprüche 1, 2 oder 4 bis 23, dadurch gekennzeichnet, daß die Elemente der III. und V. Gruppe aus den Paaren von Elementen ausgewählt werden, die Aluminium und Antimun, Aluminium und Arsen, Gallium und Arsen und Indium und Phosphor umfassen.

25. Verfahren nach einem der Ansprüche 1, 2 oder 4 bis 23, dadurch gekennzeichnet, daß die Elemente der II. und VI. Gruppe aus den Paaren von Elementen ausgewählt werden, die Kadmium und Schwefel und Kadmium und Tellur umfassen.

26. Verfahren nach einem der Ansprüche 3 bis 18, dadurch gekennzeichnet, daß das verwendete Element Silicium oder Germanium ist.

**Claims**

1. Method for preparing polycrystalline semi-conducting films comprised of two elements respectively from Groups III and V, or Groups II and VI of the Periodic Table, by irradiating with a laser beam a film which is comprised of at least two layers from elements selected with a stoichiometric ratio, said film being deposited over a non-crystalline substrate and being coated with a protective layer, which method being characterized in that it comprises irradiating said film with a structured laser beam to cause crystallizing into crystallites which are regularly aligned and with a size at least equal to the thickness of the resulting film, the laser beam being structured by passing through an optical means which is so arranged as to cause interference fringes.

2. Method as defined in claim 1, characterized in that said film is comprised of alternating layers from said elements selected with a stoichiometric ratio.

3. Method for preparing polycrystalline elementary semi-conducting films by irradiating with a laser beam an elementary amorphous semi-conducting film, said film being deposited over a non-crystalline substrate and coated with a protective layer, which method being characterized in that it comprises irradiating said film with a structured laser beam to cause crystallizing into crystallites which are regularly aligned and with a size at least equal to the thickness of the resulting film, the laser beam being structured by passing through an optical means which is so arranged as to cause interference fringes.

4. Method as defined in any one of claims 1 to 3, characterized in that said non-crystalline substrate is cleaned by ionic bombardment with a neutral gas, such as argon.

5. Method as defined in any one of claims 1 to 4, characterized in that said crystallites have a size larger than the thickness of the resulting film.

6. Method as defined in any one of claims 1 to 5, characterized in that said optical means causing interference fringes is comprised of an etched quartz optic grating.

7. Method as defined in claim 6, characterized in that the number of etched lines in the quartz optic grating and the spacing grating-film have such values that the laser beam causes a regular crystallizing over the whole surface area with aligned crystallites.

8. Method as defined in claim 7, characterized in that the number of lines in the optic grating varies between 1000 and 6000 to the cm.

9. Method as defined in either one of claims 7 and 8, characterized in that the spacing grating-film is about 1 mm.

10. Method as defined in any one of claims 1 to 5, characterized in that said optical means causing interference fringes is comprised of a Fresnel's lens.

11. Method as defined in any one of claims 1 to 5, characterized in that said optical means causing interference fringes is comprised of a metal screen or grid having a regular mesh lying at right angle to the beam axis.

12. Method as defined in any one of claims 1 to 11, characterized in that said laser beam irradiating the film operates in pulsed mode with an energy between 50 and 100 mJ/cm$^2$.

13. Method as defined in any one of claims 1 to 12, characterized in that said laser beam irradiating the film operates in continuous mode with an energy between 1 and 5 J/cm$^2$.

14. Method as defined in any one of claims 1 to 13, characterized in that said laser beam is made homogeneous before being structured.

15. Method as defined in claim 14, characterized in that said laser beam is made homogeneous by passing through a quartz cylinder-like rod which is bent twice at right angle along opposite directions, coated with a metal layer, and the input and output surfaces thereof being polished, in parallel relationship together and at right angle to the rod axis, the diameter of said rod varying from the input to the output surface by a factor of about 2.

16. Method as defined in any one of claims 1 to 15, characterized in that the film thickness lies between 1 and 2 $\mu$m, and the laser beam is comprised of a pulsed ruby laser beam.

17. Method as defined in any one of claims 1 to 16, characterized in that the film thickness lies between 2 and 25 $\mu$m and the laser beam is a continuous laser beam.

18. Method as defined in any one of claims 1 to 17, characterized in that the protective layer is comprised of silicium monooxide or indium-doped tin oxide.

19. Method as defined in any one of claims 1, 2 and 4 to 18, characterized in that the elements from Groups III and V, or II and VI of the Periodic Table are deposited over a non-crystalline substrate in alternating layers with a thickness varying between 50 and 2000 Å depending on the nature of the element, by means of an electron gun, with stoichiometric ratios, the last layer being coated with a protective layer, the thickness of the various layers being controlled by vibrating quartz.

20. Method as defined in claim 19, characterized in that the thicknesses from two different elementary layers which are directly adjacent to one another, each vary between 50 and 200 Å and are retained constant over the whole thickness of the total film, so as to obtain a homogeneous and regular piling of both said different elementary layers.

21. Method as defined in claim 20, characterized in that the thickness of the elementary layers is reduced progressively over the substrate as said layers are being deposited.

22. Method as defined in claim 21, characterized in that the first sandwiches have a thickness in the range from 0.1 to 0.5 $\mu$m and the last sandwich has a thickness in the range of 150 Å, each sandwich being formed by two different elementary layers which are directly adjacent.

23. Method as defined in any one of claims 20 to 22, characterized in that the last layer being deposited is comprised of the less-absorbing element.

24. Method as defined in any one of claims 1, 2 and 4 to 23, characterized in that the elements from Groups III and V are selected respectively among those element couples which comprise aluminum and antimony, aluminum and arsenic, gallium and arsenic, and indium and phosphorus.

25. Method as defined in any one of claims 1, 2 and 4 to 23, characterized in that the elements from Groups II and VI are selected respectively among those element couples which comprise cadmium and sulfur, and cadmium and tellurium.

26. Method as defined in any one of claims 3 to 18, characterized in that the element used is silicium or germanium.